# EUROPEAN PATENT SPECIFICATION

(11) **EP 4 283 011 B1**
(45) Date of publication and mention of the grant of the patent: **21.08.2024**
(21) Application number: 22461556.7
(22) Date of filing: 26.05.2022
(51) Int. Cl.: C23C 14/35, H01J 37/34

(54) **MAGNETRON DEVICE FOR SPUTTERING TARGET**
MAGNETRONVORRICHTUNG FÜR SPUTTERTARGET
DISPOSITIF À MAGNÉTRON POUR UNE CIBLE DE PULVÉRISATION

(43) Date of publication of application: 29.11.2023
(73) Proprietor: Instytut Fizyki Polskiej Akademii Nauk, 02-668 Warszawa (PL); Prevac Spolka Z Ograniczona Odpowiedzialnoscia, 44-362 Rogow (PL)
(72) Inventor: Fronc, Krzysztof, 01-417 Warszawa (PL); Chojnacki, Michal, 01-357 Warszawa (PL); Glenz, Andreas, 44-362 Rogow (PL)
(74) Representative: Bury & Bury

(56) References cited:
- EP-A2- 0 144 572
- DE-A1- 3 429 988
- JP-A- H05 295 537
- JP-A- S6 338 576
- PL-B1- 234 256
- US-A- 4 370 217
- US-A- 4 652 358

## Description

### Technical field

The invention concerns a device for magnetron sputtering from a target.

### Background of the invention

From the Polish patent PL234256B1 a magnetron for metal sputtering is known, which has a cylindrical casing and a base, on which a assembled target is embedded, having a disc made from a first pure metal in solid state, on which there is at least one plate made from a second pure metal in solid state and at least one graphite vessel containing liquid pure gallium. Additionally, the assembled target is provided with an annular outer pole-piece and a central supporting magnet in a shielding. Inside the base of the magnetron, there is a main assembled magnet placed in a brass can supported by a Teflon holder. A disadvantage of this solution is a non-uniform erosion of the target, due to an inclination of the magnetic field vector with respect to the target, what only partially improves the central supporting magnet.

From the European patent publication EP1449234 a target unit for vacuum sputtering is known, comprising a main target and a supporting target made from a ferromagnetic material. The supporting target is elevated above the main target, so after applying the magnetic field to the supporting target above the main target, a magnetic field substantially parallel to the main target is formed. Thanks to that, a uniform erosion can be obtained. However, such configuration results in inconveniences. The supporting target must be close to a magnetic field source - otherwise, the field above the main target is too weak. Due to that, it is difficult to provide sufficiently efficient cooling system. Using non-efficient cooling systems and isolation of permanent magnets from high temperatures can cause damage and a loss of the magnetic properties of the magnets.

In case of sputtering ferromagnetic materials, an additional problem is that the target shields the magnetic field and it is difficult to obtain a sufficient strength magnetic field.

A suboptimal field distribution above the target results in a non-uniform distribution of plasma during an operation and as a result a necessity for a frequent replacement of the target which is not fully used. JPS6338576A discloses a method for efficiently generation of a leakage magnetic field near the surface of a target to improve the utilizing efficiency of the target and the uniformity of a film thickness by providing yokes in a backing plate of a magnetron. EP0144572 discloses magnetron-cathodes for the sputtering of ferromagnetic targets having magnet system arranged on a cathode base body. The magnet system consists of nested magnetic poles of opposite polarity. Two circumferential air gaps are formed between pole pieces. For the purpose of evening out the target removal while maintaining a high sputtering rate, the pole pieces are each separated from the magnetic poles by a distance "S". Between the target and the magnetic poles, a heat-conducting metal body is arranged, which is connected to at least one coolant channel and consists of a non-ferromagnetic material. DE3429988 discloses a magnetron cathode for sputtering ferromagnetic targets. Disposed on a cathode base body there is a magnet system which consists of nested magnetic poles of opposite polarity. Between pole pieces consisting of target material and the target, two circumferential air gaps are formed in the depth direction of the configuration. Magnetic poles and targets do not intersect in a projection plane. In order to render the target erosion uniform while maintaining a high sputtering rate, the pole pieces are each separated from the magnetic poles by a spacing "S". on the one hand, and the magnetic poles on the other hand, a thermally conductive metal body is disposed which is in contact with at least one coolant duct and consists of a non-ferromagnetic material.

US4370217 discloses a target assembly comprising, for use in a magnetron-type sputtering device. The target assembly comprises a magnetic target plate and first and second permanent magnet pieces brought into contact with the target plate circumferentially and centrally of the target plate with differently named poles of the respective magnet pieces placed nearer to the target plate. The magnet pieces may be attached to that surface of the target plate which is directed to a hollow space of the sputtering device. A conductive body is placed in contact with the target plate on the side opposite to the above-mentioned surface to serve as an electrode. The conductive body is preferably made of a soft magnetic material. US4652358 discloses a cathode system for sputtering apparatus which includes a target plate of ferromagnetic material. A magnet system is situated behind the target plate and has opposed poles positioned so that at least a portion of the lines of force emerging from the poles passes out through the target and returns thereto. The target is placed on a floor which includes strips of ferromagnetic material in the area of the poles of the magnet system. These strips close the magnetic circuit between the magnet system and the target plate. The remainder of the floor is made of nonmagnetic material. JPH05295537 discloses a target formed from material comprising Co-Cr-Ta alloy that has the high magnetic anisotropy of crystals and the small magnetic permeability as the target is magnetically hardened. Therefore, the rate at which the magnetic lines of force by the magnet passes the inside of the target is small and a powerful magnetic field is formed above the target. This helps to increase the ionization efficiency during glow discharge. Since the plasma density is increased, the sputtering efficiency of the target alloy is improved.

### Technical problem

The technical problem is to provide a magnetic field parallel to the surface of the target, which will have a sufficient strength and obtained in a configuration which allows its secure cooling.

### Summary of the invention

It is an object of the invention to provide a solution for above described problem.

A device for magnetron sputtering from a target according to the invention comprises a cylindrical shield casing, inside of which there is an outer tube. In the outer tube there are concentrically placed: an inner central magnet and an annular outer magnet and an inner tube placed between them. Below the magnets a bottom pole-piece is placed, through which two sealed, hollow tubes protrude, for supplying and discharging a cooling fluid. Above the magnets, a base of the target is placed, on which the annular outer pole-piece is placed and in which the inner pole-piece is placed. Between the outer pole-piece and the inner pole-piece there is a disc shaped target. The device according to the invention is distinguished by the fact that between the outer pole-piece and the outer magnet, an outer magnetic circuit is provided, made of mu-metal, having a shape of a ring tapering towards the target, between the inner pole-piece and the inner magnet there is an inner magnetic circuit made of mu-metal and having a shape of a truncated cone tapering towards the target. The inner tube has a partially conical shape in its upper part and channels for the cooling fluid are provided in it, connected to the hollow tubes. The base of the target is created by concentrically placed and tightly fitted and tightly connected: the outer tube, the outer magnetic circuit, the upper part of the inner tube, the inner magnetic circuit. The disc shaped target is made of a ferromagnetic material. Between the disc shaped target and the pole-pieces, a horizontal distance is provided. Thanks to the use of the pole-pieces brought above the base, a magnetic field above the target having a parallel component of the field can be obtained, and simultaneously the shielding effect of the field by the target can be avoided. Consequently a ring of plasma above the disc shaped target can be created. The use of magnetic circuits allows for locating away the magnets from the surface of the base, without a significant decreasing of a value of the magnetic field induction close to the target. This additional space allows for providing an efficient cooling system in a form of channels in the upper part of the inner tube, completely separated from the magnets prone to corrosion. Thanks to the use of the conical shapes, a pressure force, caused by pressure difference above and below the base of the target, is transferred to the outer tube and it does not stress the tight connections.

Advantageously, the outer tube, the outer magnetic circuit, the upper part of the inner tube, the inner magnetic circuit creating the base of the target are connected by high-temperature soldering. The high-temperature soldering is a convenient method of connecting, allowing for efficient and tight bonding of mu-metal with copper, which is a convenient material for making non-magnetic elements of the base of the target. This connection can be used thanks to the used conical shapes, which reduce the load force of the connection.

The device advantageously comprises an inner ring made of a non-magnetic material and an outer ring, adapted for positioning of the disc shaped target placed between them. Thanks to them it is possible to place the target on the base more precisely.

The outer pole-piece is advantageously provided with an outer shield, and the inner pole-piece is provided with an inner shield. The shields prevents erosion due to the plasma interaction of the pole-pieces and the outer ring and the inner ring.

The outer shield and the inner shield are advantageously made of the same ferromagnetic material as the disc shaped target. Such solution allows for sputtering without contamination by other material, even if created plasma is not placed only above the disc shaped target.

Advantageously, the outer pole-piece and the inner pole-piece are made of the same ferromagnetic material as the disc shaped target. The outer pole-piece and the outer shield can then be one solid element, whereas the inner pole-piece and the inner shield can then be a second solid element.

The disc shaped target advantageously has a thickness in the range from 1 to 6 mm. Such thickness of the disc shaped target allows for long operation without exchange and it is not detrimental to the field distribution.

Advantageously, the disc shaped target has a thickness greater than or equal to 3 mm. The discs with the thickness of 3 mm or greater proved to be convenient in exploitation.

### Short description of figures

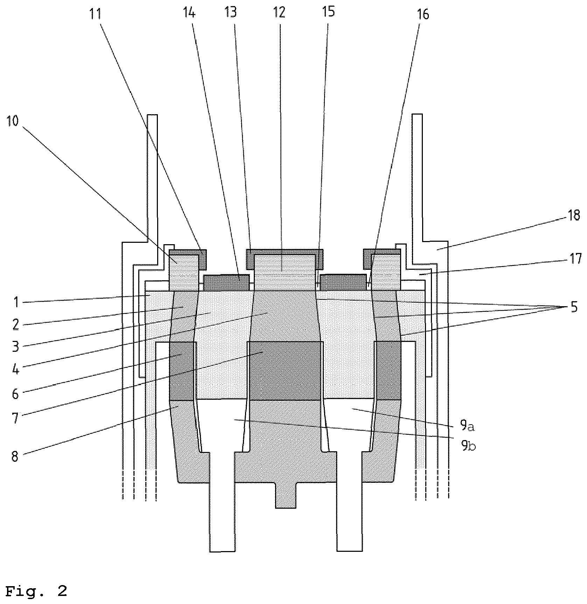

The invention has been described in detail below in exemplary embodiments, presented with reference to the attached figures, wherein Fig. 1 presents the device for magnetron sputtering according to the invention in a perspective view, whereas Fig. 2 presents the device for magnetron sputtering in a longitudinal cross-section, Fig. 3 presents the magnetic field distribution in the device for magnetron sputtering according to the invention with the disc shaped target having thickness of 3 mm, Fig. 4 presents the magnetic field distribution in the device for the magnetic sputtering according to the invention with the disc shaped target having thickness of 6 mm, Fig. 5 presents the magnetic field distribution in a device known from the state-of-the-art with the disc shaped target having thickness of 2, 5 mm.

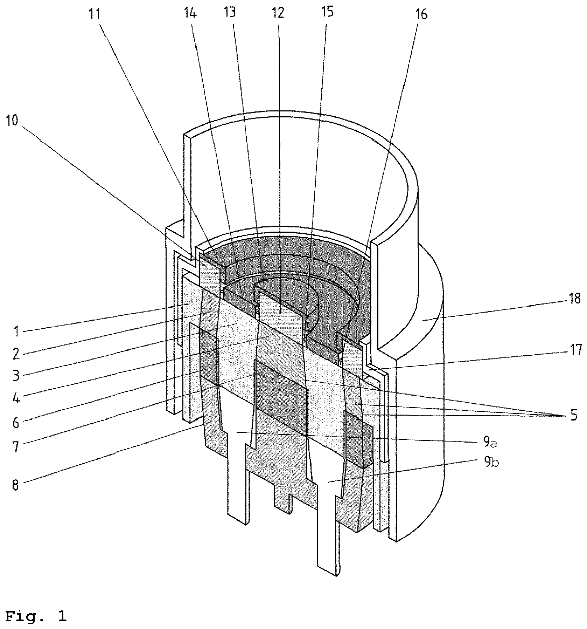

The magnetron shown in Fig. 1 has an essentially cylindrical shape. The target is placed on the base formed by concentrically placed and tightly fitted and connected the outer tube **1**, the magnetic circuit **2**, the upper part of the inner tube **3**, and the inner magnetic circuit **4**. Those elements are essentially axially symmetrical and they have wedge shape so they wedge up when pressure is applied, prompted by the pressure difference above and below the base. This effect was obtained by giving those elements the shape of truncated cones. Additionally, the connection **5** by soldering was used. The pressure difference during working conditions is significant, because below the base there is atmospheric pressure. However, above the base, in the area, in the working chamber in which the target is sputtered, the state of ultra-high vacuum prevails. Only for the sputtering time, the working chamber is filed with sputtering gas under the low pressure.

Such configuration of the base according to the invention, contributes to an effect of shielding of the magnetic field by the base is avoided, because magnetic circuits **2**, **4** constitute a connection of an assembly of magnets-**6**, **7** with the pole-pieces placed above the base of the target.

On the base an annular outer pole-piece **10** is placed, to which the outer magnetic circuit **2** guides the magnetic field, and concentrically placed an inner pole-piece **12** inside the outer pole-piece **10.** The magnetic field is guided to the inner pole-piece **12** by the inner magnetic circuit **4.** Between the outer pole-piece **10** and the inner pole-piece **12**, there is placed a disc shaped target **14** intended for sputtering.

The central magnet **7** and an annular outer magnet **6** placed below the base are sources of the magnetic field. The inner central magnet **4** guides the magnetic field to the inner pole-piece **12** through the inner magnetic circuit **4.** The annular outer magnet **6** guides the magnetic field to the outer pole-piece **10** through the outer magnetic circuit **2.** From the bottom, the magnetic field is closed by the bottom pole-piece **8.** The inner central magnet **7** and the outer magnet **6** are arranged concentrically. The inner central magnet **7** is a cylindrical permanent magnet and the outer magnet **6** is an annular permanent magnet. Between those magnets, there is an inner tube **3.** Above the magnets, this tube in its upper part, entering the base is narrowing linearly passing into the shape of a cone.

The outer tube **1** and the inner tube **3** are made of copper. Other non-magnetic material with high thermal conductivity can be used, however this material should additionally meet a number of requirements: exhibit resistance to increased temperature and corrosion and demonstrate susceptibility to bonding with other materials via welding/sputtering and moreover said material cannot evaporate in vacuum. Copper is one of a few materials which meets those requirements. In the inner tube **3**, the channels of the cooling fluid are provided for cooling. The channels of the cooling fluid are connected with the hollow tubes **9a**, **9b** passing through the bottom pole-piece **8.** The hollow tubes **9a** and **9b**, respectively supply and discharge the cooling fluid.

The outer magnetic circuit **2** and the inner magnetic circuit **4** are made of mu-metal. Mu-metal is nickel, iron and molybdenum alloy which guides the magnetic field well and which is resistant to corrosion in a contact with water, what enables efficient cooling. Thanks to that the inner magnet **7** and the outer magnet **6** are separated from the cooling fluid, which threatens them with corrosion and from the heated target.

The target is provided in a form of the disc shaped target **14**, arranged on the base between the outer annular pole-piece **10** and the cylindrical inner pole-piece **12.** The magnetron efficiently sputtered the target from different discs made of ferromagnetic materials, in particular the disc shaped targets having the thickness from 1 to 6 mm. In particular, the discs of ferromagnetic target having a thickness greater than 3 mm were sputtered well, what is unobtainable by means of the magnetrons known in the state-of-the-art.

The magnetron has casing **18**, inside which there is an outer tube **1**, having in it a multistep positioning tube **17**, which fastens-the elements, including the target to the base. When the target is entirely ferromagnetic, fastening by means of the tube **17** is basically redundant, because the target is held by the magnetic field. When the shield **11** is non-magnetic, then it should be fastened. The cylindrical casing **18** limits the sputtering area, i.e. the space in which the target is sputtered, directing a sputtered material to one side and additionally it constitutes a grounded counter electrode of the target which is under high voltage during sputtering. Therefore, between the casing **18** and the outer tube **1** and the multistep tube **17**, a spacing preventing short circuit is provided.

The use of the outer pole-piece **10** and the inner pole-piece **12** overhanging above the disc shaped target and connected by the outer magnetic circuits **2**, **4** with the outer magnet **6** and the inner magnet **7**, allowed for limiting the shielding of the magnetic field by the ferromagnetic target as well. The magnetic field in this construction is closed above the disc shaped target **14** and has force lines of the field parallel to the surface of this disc shaped target **14.** Thanks to that, plasma is created uniformly above the disc shaped target **14** and its erosion is uniform, and the surface, from which the material is sputtered, is bigger than in a case of conventional solutions. For obtaining the advantageous field distribution, it is crucial for the pole-pieces to be made of the ferromagnetic material. It can be the same material, from which the disc shaped target is made. Then, the pole-piece with the field can be made as one solid element. Spaces between the pole-pieces **10**, **12** and the disc shaped target **14** prevent closing the magnetic field entirely by the target and thanks to that the field is placed also in a space above the disc shaped target **14.**

In the spaces between the disc shaped target **14** and the pole-pieces **10**, **12**, positioning rings **15**, **16** are placed respectively. Those rings are made from the non-magnetic material, i.e. from copper and they provide a constant spacing and they concentrically position the disc shaped target **14** on the base.

Additional improvement is obtained by using the outer shield **11** of the outer pole-piece **10** and the inner shield **13** of the inner pole-piece **12.** Then, other materials than the target material can be freely used for making the pole-pieces. The shields prevent the pole-pieces against the effects of plasma and they allow for avoiding a contamination of the sputtered material flux by the material of the pole-pieces.

The shields **11**, **13** need not to be made of the ferromagnetic material. It is possible to sputter various magnetic materials as nickel, cobalt, and non-magnetic, as aluminum, titanium, copper, niobium, tungsten, rhenium, silver, gold, platinum, palladium etc. The shields **11**, **13** prevent erosion and sputtering of the positioning rings **15**, **16** as well as the contamination of the sputtered material.

During the use of the device according to the invention, it is placed in the vacuum chamber, to which a small amount of sputtering gas is added during the sputtering time, which enables plasma formation. At an outlet of the casing **18**, within a short distance - exemplary 10 cm, a substrate is placed, which the sputtered material of the target should reach and the atmospheric gases are pumped out of it in order to obtain a high vacuum. For the sputtering time, the vacuum chamber is filed with the sputtering gas under low-pressure which allows for plasma formation. The electric potential difference is applied to the casing and to the target.

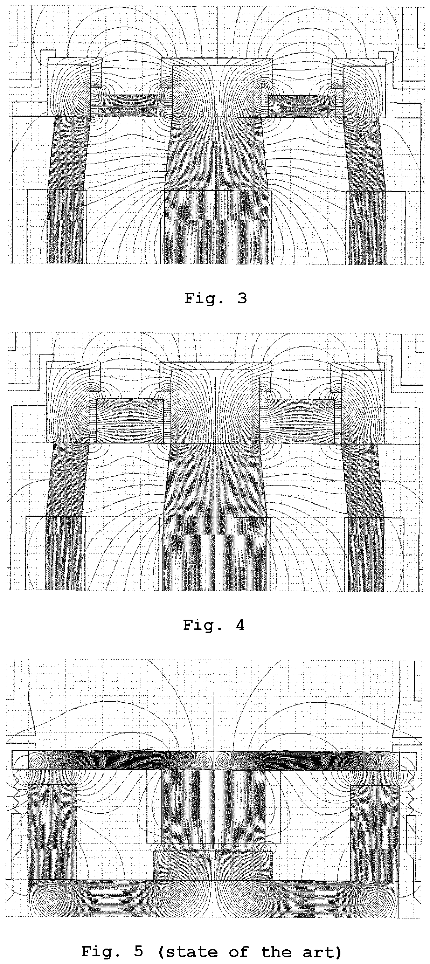

The base of the target constitutes a barrier between the high vacuum of the chamber and atmospheric pressure from the outside and/or pressure of the cooling fluid. In conventional two-inch magnetrons, copper bases having the thickness of several millimeters are used. In a case of using bigger diameters, the pressing force of gas/fluid forces using even greater thicknesses in order to avoid deformations. That in turn results in that the magnets are distanced from the material of the target and the magnetic field strength decreases. The invention allows for avoiding that, using the thicker base and providing more efficient cooling in hollow channels. Thus, the device is less exposed to mechanical damages due to the pressure difference and magnets are better isolated from high temperatures, which are harmful for them. In Fig. 3 and Fig. 4 this effect is shown for the targets having thickness of 3 mm and 6 mm, in comparison to a 2,5 mm target of a construction known in the-state-of-the-art. The solution according to the invention allows for obtaining a higher magnetic field strength and its more advantageous distribution, despite using the thicker target and locating it away from the magnet, further than it takes place for solutions known from the state-of-the-art.

## Claims

1. A device for magnetron sputtering from a target comprising
a cylindrical shaped casing (**18**), inside of which there is an outer tube (**1**), comprising concentric arrangement of:
an inner central magnet (**7**) and
an annular outer magnet (**6**), with
an inner tube (**3**) placed between them,
and, below magnets there is a bottom pole-piece (**8**), through which two sealed, hollow tubes (**9a**, **9b**) protrude, for distributing in and distributing-out a cooling fluid,
wherein above the magnets, there is located a base of the target and on said base, there are provided
an angular outer pole-piece (**10**) with an inner pole-piece (**12**) placed in the outer pole-piece (**10**),
whereas between the outer pole-piece (**10**) and the inner pole-piece (**12**) a disc shaped target (**14**) is placed
the disc shaped target (**14**) is made of ferromagnetic material, wherein between the disc shaped target (**14**) and the pole-pieces (**10**, **12**) a horizontal distance is provided
**characterized in that**
between the outer pole-piece (**10**) and the outer magnet (**6**) there is provided an outer magnetic circuit (**2**), made of mu-metal, having a shape of a ring tapering towards the target,
between the inner pole-piece (**12**) and the inner magnet (**7**) there is an inner magnetic circuit (**4**) made of mu-metal and having a shape of a truncated cone
whereas
the inner tube (**3**) has in its upper part a partially conical shape and is provided with channels for the cooling fluid, connected to the hollow tubes (**9a**, **9b**),
wherein
the base of the target is formed by concentrically placed and tightly fitted and connected:
the outer tube (**1**),
the outer magnetic circuit (**2**),
the upper part of the inner tube (**3**),
the inner magnetic circuit (**4**).

2. Device for magnetron sputtering according to claim 1, wherein,
the outer tube (**1**),
the outer magnetic circuit (**2**),
the upper part of the inner tube (**3**),
the inner magnetic circuit (**4**),
forming the base of the target are connected by high-temperature soldering.

3. Device for magnetron sputtering according to claim 1 or 2, wherein, it comprises an inner ring (**15**) made of a non-magnetic material and an outer ring (**16**), adapted for positioning of the disc shaped target (**14**) between them.

4. Device for magnetron sputtering according to claim 1 or 2 or 3, wherein, the outer pole-piece (**10**) is provided with an outer shield (**11**), and the inner pole-piece (**12**) is provided with an inner shield (**13**).

5. Device for magnetron sputtering according to claim 1 or 2 or 3 or 4, wherein, the outer shield (**11**) and the inner shield (**13**) are advantageously made of the same ferromagnetic material as the disc shaped target (**14**).

6. Device for magnetron sputtering according to any of claims from 1 to 3, wherein the outer pole-piece (**10**) and the inner pole-piece (**12**) are made of the same ferromagnetic material as the disc shaped target, and
the outer pole-piece (**10**) and the outer shield (**11**) constitute one solid element, whereas
the inner pole-piece (**12**) and the inner shield (**13**) constitute another solid element.

7. Device for magnetron sputtering according to any of claims from 1 to 6, wherein the disc shaped target (**14**) has a thickness in a range from 1 to 6 mm.

8. The device for magnetron sputtering according to any of claims from 1 to 6, wherein the disc shaped target (**14**) has thickness greater than 3 mm.

## Patentansprüche

1. Vorrichtung zum Magnetronsputtern von einem Target umfassend
ein zylindrisch geformtes Gehäuse (**18**), in dessen Innerem sich ein äußeres Rohr befindet (**1**), das eine konzentrische Anordnung aus
einem inneren zentralen Magneten (**7**) und
einem ringförmigen äußeren Magneten (**6**) umfasst, wobei zwischen diesen ein inneres Rohr (**3**) angeordnet ist,
und, wobei sich unterhalb der Magnete ein unterer Polschuh (**8**) befindet, durch welchen zwei abgedichtete, hohle Rohre (**9a**, **9b**) ragen, um Kühlflüssigkeit hinein- und hinauszuleiten,
wobei sich über den Magneten eine Basis des Targets befindet und auf dieser Basis
ein winkelförmiger äußerer Polschuh (**10**) mit einem in dem äußeren Polschuh (**10**) angeordneten inneren Polschuh (**12**) vorgesehen ist,
wobei zwischen dem äußeren Polschuh (**10**) und dem inneren Polschuh (**12**) ein scheibenförmiges Target (**14**) angeordnet ist, das aus ferromagnetischem Material besteht,
wobei zwischen dem scheibenförmigen Target (**14**) und den Polschuhen (**10**, **12**) ein horizontaler Abstand vorgesehen ist
**dadurch gekennzeichnet, dass**
zwischen dem äußeren Polschuh (**10**) und dem äußeren Magneten (**6**) ein äußerer Magnetkreis (**2**) aus Mu-Metall vorgesehen ist, der die Form eines sich zum Target hin verjüngenden Rings hat,
zwischen dem inneren Polschuh (**12**) und dem inneren Magneten (**7**) ein innerer Magnetkreis (**4**) aus Mu-Metall vorgesehen ist, der die Form eines Kegelstumpfes hat,
während
das innere Rohr (**3**) in seinem oberen Teil eine teilweise konische Form hat und mit Kanälen für die Kühlflüssigkeit versehen ist, die mit den hohlen Rohren (**9a**, **9b**) verbunden sind,
wobei
die Basis des Targets gebildet ist durch
das äußere Rohr (**1**),
der äußere Magnetkreis (**2**),
der obere Teil des inneren Rohrs (**3**),
der innere Magnetkreis (**4**),
welche konzentrisch angeordnet und fest eingepasst und verbunden sind.

2. Vorrichtung zum Magnetronsputtern nach Anspruch 1, **dadurch gekennzeichnet, dass**
das äußere Rohr (**1**),
der äußere Magnetkreis (**2**),
der obere Teil des inneren Rohres (**3**),
der innere Magnetkreis (**4**),
welche die Basis des Targets bilden, durch Hochtemperaturlöten verbunden sind.

3. Vorrichtung zum Magnetronsputtern nach Anspruch 1 oder 2, **dadurch gekennzeichnet, dass** sie einen inneren Ring (**15**) aus nichtmagnetischem Material und einen äußeren Ring (**16**) umfasst, die so beschaffen sind, dass sie das scheibenförmige Target (**14**) zwischen sich positionieren können.

4. Vorrichtung zum Magnetronsputtern nach Anspruch 1, 2 oder 3, **dadurch gekennzeichnet, dass** der äußere Polschuh (**10**) mit einer äußeren Abschirmung (**11**) und der innere Polschuh (**12**) mit einer inneren Abschirmung (**13**) versehen sind.

5. Vorrichtung zum Magnetronsputtern nach Anspruch 1, 2, 3 oder 4, **dadurch gekennzeichnet, dass** die äußere Abschirmung (**11**) und die innere Abschirmung (**13**) vorzugsweise aus dem gleichen ferromagnetischen Material wie das scheibenförmige Target (**14**) bestehen.

6. Vorrichtung zum Magnetronsputtern nach einem der Ansprüche 1 bis 3, **dadurch gekennzeichnet, dass** der äußere Polschuh (**10**) und der innere Polschuh (**12**) aus dem gleichen ferromagnetischen Material wie das scheibenförmige Target bestehen und der äußere Polschuh (**10**) und die äußere Abschirmung (**11**) ein festes Element bilden, während der innere Polschuh (**12**) und die innere Abschirmung (**13**) ein weiteres festes Element bilden.

7. Vorrichtung zum Magnetronsputtern nach einem der Ansprüche 1 bis 6, **dadurch gekennzeichnet, dass** das scheibenförmige Target (**14**) eine Dicke im Bereich von 1 bis 6 mm aufweist.

8. Vorrichtung zum Magnetronsputtern nach einem der Ansprüche 1 bis 6, **dadurch gekennzeichnet, dass** das scheibenförmige Target (**14**) ein Dicke von mehr als 3 mm aufweist.

## Revendications

1. Dispositif de pulvérisation magnétron à partir d'une cible comprenant un boîtier de forme cylindrique (**18**), à l'intérieur duquel se trouve
un tube extérieur (**1**), comprenant un agencement concentrique de :
un aimant central intérieur (**7**) et
un aimant extérieur annulaire (**6**), avec
un tube intérieur (**3**) placé entre eux,
et, au-dessous des aimants, se trouve une pièce polaire inférieure (**8**), à travers laquelle deux tubes creux scellés (**9a**, **9b**) font saillie, pour distribuer à l'intérieur et à l'extérieur un fluide de refroidissement,
dans lequel, au-dessus des aimants, se trouve une base de la cible et sur ladite base sont prévues
une pièce polaire extérieure angulaire (**10**) avec une pièce polaire intérieure (**12**) placée dans la pièce polaire extérieure (**10**),
tandis qu'une cible en forme de disque (**14**) est placée entre la pièce polaire extérieure (**10**) et la pièce polaire intérieure (**12**)
la cible en forme de disque (**14**) est constituée d'un matériau ferromagnétique, dans lequel une distance horizontale est prévue entre la cible en forme de disque (**14**) et les pièces polaires (**10**, **12**),
**caractérisé en ce que**
entre la pièce polaire extérieure (**10**) et l'aimant extérieur (**6**), est prévu un circuit magnétique extérieur (**2**), en mu-métal, ayant la forme d'un anneau se rétrécissant vers la cible,
entre la pièce polaire intérieure (**12**) et l'aimant intérieur (**7**) se trouve un circuit magnétique intérieur (**4**) en mu-métal et ayant une forme de cône tronqué
tandis que
le tube intérieur (**3**) a dans sa partie supérieure une forme partiellement conique et est pourvu de canaux pour le fluide de refroidissement, reliés aux tubes creux (**9a**, **9b**),
dans lequel
la base de la cible est formée par des éléments placés de manière concentrique, étroitement ajustés et reliés :
le tube extérieur (**1**),
le circuit magnétique extérieur (**2**),
la partie supérieure du tube intérieur (**3**),
le circuit magnétique intérieur (**4**).

2. Dispositif de pulvérisation magnétron selon la revendication 1, dans lequel,
le tube extérieur (**1**),
le circuit magnétique extérieur (**2**),
la partie supérieure du tube intérieur (**3**),
le circuit magnétique intérieur (**4**),
formant la base de la cible sont reliés par soudure à haute température.

3. Dispositif de pulvérisation magnétron selon la revendication 1 ou 2, dans lequel il comprend un anneau intérieur (**15**) constitué d'un matériau non magnétique et un anneau extérieur (**16**), adapté pour positionner la cible en forme de disque (**14**) entre eux.

4. Dispositif de pulvérisation magnétron selon la revendication 1 ou 2 ou 3, dans lequel la pièce polaire extérieure (**10**) est munie d'un écran extérieur (**11**), et la pièce polaire intérieure (**12**) est munie d'un écran intérieur (**13**).

5. Dispositif de pulvérisation magnétron selon la revendication 1 ou 2 ou 3 ou 4, dans lequel l'écran extérieur (**11**) et l'écran intérieur (13) sont avantageusement constitués du même matériau ferromagnétique que la cible en forme de disque (**14**).

6. Dispositif de pulvérisation magnétron selon l'une des revendications 1 à 3, dans lequel la pièce polaire extérieure (**10**) et la pièce polaire intérieure (**12**) sont constituées du même matériau ferromagnétique que la cible en forme de disque, et
la pièce polaire extérieure (**10**) et l'écran extérieur (**11**) constituent un seul élément solide, tandis que
la pièce polaire intérieure (**12**) et l'écran intérieur (**13**) constituent un autre élément solide.

7. Dispositif de pulvérisation magnétron selon l'une des revendications 1 à 6, dans lequel la cible en forme de disque (**14**) a une épaisseur dans une plage allant de 1 à 6 mm.

8. Dispositif de pulvérisation magnétron selon l'une des revendications 1 à 6, dans lequel la cible en forme de disque (**14**) a une épaisseur supérieure à 3 mm.
